# EUROPÄISCHE PATENTANMELDUNG

(11) **EP 1 879 439 A1**
(43) Veröffentlichungstag der Anmeldung: **16.01.2008**
(21) Anmeldenummer: 06014306.2
(22) Anmeldetag: 11.07.2006
(51) Int. Cl.: H05K 5/02

(54) **Druckausgleichselement**

(71) Anmelder: RST Rabe-System-Technik GmbH, 49134 Wallenhorst (DE)
(72) Erfinder: Diedler, Thomas, 49565 Bramsche/ Engter (DE)
(74) Vertreter: Engelmann, Kristiana

(57) **Zusammenfassung**

Die Erfindung betrifft ein Druckausgleichselement 2 zum Verschließen eines Zugangs zu einem Gehäuse, mit einem Aufnahmeteil 4, in dem eine semipermeable Membran 6 angeordnet ist, und einem das Aufnahmeteil 4 zumindest bereichsweise verschließenden Deckel 8. Um trotz kompakter Bauweise des Druckausgleichselements 2 einen hohen Schutz von äußeren Einflüssen bei gleichzeitig kostengünstiger Herstellung zu erzielen, weist das Druckausgleichselement 2 zwischen dem Deckel 8 und der Membran 6 ein Labyrinthsystem 24 auf, das die Membran 6 vor an dem Deckel 8 vorbei in das Aufnahmeteil 4 eindringenden Fremdkörpern schützt.

## Beschreibung

Die Erfindung betrifft ein Druckausgleichselement nach dem Oberbegriff des Patentanspruchs 1 und eine Anordnung nach dem Oberbegriff des Anspruchs 18.

Im Inneren dicht ausgebildeter Gehäuse kann bei einem Wechsel der klimatischen Gegebenheiten unerwünscht Kondenswasser gebildet werden. Um die Kondenswasserbildung zu verhindern, ist bekannt, das Gehäuse mit einem Druckausgleichselement zu versehen.

Das Druckausgleichselement wird dabei in eine individuell angepaßte Bohrung des Gehäuses eingeschraubt. Im Inneren des Druckausgleichselements ist eine luftdurchlässige jedoch wasserundurchlässige Membran (semipermeabel) angeordnet, die das Gehäuseinnere vom Gehäuseäußeren abtrennt. Luftfeuchtigkeit kann aus dem Gehäuse durch die Membran entweichen. Spritzwasser wird dagegen durch die Membran vom Gehäuseinneren ferngehalten.

Die Druckausgleichselemente bestehen aus einem Aufnahmeteil, in dem die Membran untergebracht ist, und einem das Aufnahmeteil zumindest teilweise verschlie-βenden Deckel. Der Deckel wird dabei auf das Aufnahmeteil aufgesteckt. An dem Deckel vorbei in das Aufnahmeteil gelangende Fremdkörper, wie spitze Gegenstände oder der Strahl eines Hochdruckreinigers, können die Membran und damit die Funktionsfähigkeit des Druckausgleichselements beschädigen. Ergänzende Schutzvorrichtungen an der Außenseite des Gehäuses zur Abschirmung des Druckausgleichselements sind einerseits kostenintensiv und zudem auch sperrig. Erwünscht ist jedoch eine kompakte und wenig sperrige Bauweise des Druckausgleichselements und dessen Schutzes.

Der Erfindung liegt daher das Problem zugrunde, ein Druckausgleichselement bereitzustellen, das trotz kompakter Bauweise einen hohen Schutz vor äußeren Einflüssen bietet und gleichzeitig kostengünstig in der Herstellung ist.

Die Erfindung löst dieses Problem durch ein Druckausgleichselement mit den Merkmalen des Patentanspruchs 1 sowie durch eine Anordnung mit den Merkmalen des Anspruchs 18.

Dadurch, daß das Druckausgleichselement zwischen dem Deckel und dem Aufnahmeteil ein Labyrinthsystem aufweist, wird die Membran wirksam und dennoch kostengünstig vor äußeren Einflüssen geschützt. An dem Deckel vorbei in das Aufnahmeteil eindringende Fremdkörper, wie beispielsweise ein Draht oder auch die Flüssigkeit eines Hochdruckreinigers, können dadurch nicht mehr auf einem geraden Weg und mit ungebremster Kraft auf die Membran treffen. Die Bauweise des Druckausgleichselements ist dabei kompakt und nicht sperrig.

Die Fremdkörper werden bevorzugt, bezogen auf ihre Eintrittsrichtung in das Aufnahmeteil, innerhalb des Labyrinthsystems um mindestens 90 Grad, besser um 120 Grad, noch besser um 150 Grad und insbesondere um mindestens 180 Grad abgelenkt. Die Bewegungsrichtung eines in das Labyrinthsystem eingedrungenen Fremdkörpers wird wenigstens zeitweilig um den vorgenannten Winkel relativ zur Eintrittsrichtung abgelenkt. Dabei kann die Ablenkung auch das Resultat mehrerer vorangegangener Einzelablenkungen sein.

In einer bevorzugten Ausgestaltung der Erfindung ist der Deckel als Schlagschutzelement ausgebildet. Mit Vorteil sind das Schlagschutzelement und das Aufnahmeteil als einteilige Kapsel ausgebildet. Hierdurch ist der Schutz des Druckausgleichselements gegenüber äußeren Einflüsen, wie z.B. Schlägen und Stößen, trotz kleiner Bauweise weiter deutlich gegenüber herkömmlichen Druckausgleichselementen gesteigert. Der Schutz wirkt sich insbesondere im den Zugang des Gehäuses verschließenden Zustand des Druckausgleichselements aus. Das Kapselinnere wird dabei von der dem Schlagschutzelement abgewandten Seite der Kapsel mit der Membran befüllt.

Bevorzugt bildet dabei die Kapsel die alleinige Außenhülle des Druckausgleichselements. Dies bedeutet, daß keine weiteren, separaten Elemente des Druckausgleichselements außerhalb der Kapsel angeordnet sind. Das Druckausgleichselement weist dabei insbesondere keinen weiteren Schutzdeckel auf, der den ersten Deckel bzw. das Schlagschutzelement seinerseits vor Schlägen schützt. Zur Be- und Entlüftung des Kapselinneren und darüber indirekt des Inneren des Gehäuses weist der Deckel in einer vorteilhaften Ausgestaltung zumindest einen Durchbruch auf.

In einer vorteilhaften Ausgestaltung der Erfindung ist der Deckel außenseitig abgerundet. Die vom Kapselinneren wegweisende Fläche des Deckels weist dabei insbesondere die Form einer Kugelkappe oder einer Kappe eines oval geformten Körpers auf. Die Angriffsfläche des Deckels wird dadurch minimiert.

Die Erfindung sieht ferner eine Anordnung mit einem erfindungsgemäßen Druckausgleichselement und einer Kabelverschraubung eines Gehäuses vor, wobei die äußere Form des Druckausgleichselements komplementär zur inneren Form der Kabelverschraubung ausgebildet ist. Dabei wird das Druckausgleichselement bevorzugt mittels Hutmutter in der Kabelverschraubung fixiert. Die Kabelverschraubung weist ihrereseits bevorzugt eine hohe Schlag- und Stoßfestigkeit auf. Durch die Unterbringung des Druckausgleichselements in einer derartigen Kabelverschraubung wird der Schutz des Druckausgleichselements weitgehend von der Kabelverschraubung übernommen. Der Eigenschutz des Druckausgleichselements beschränkt sich lediglich auf die Flächen, die nicht von der Kabelverschraubung umschlossen sind und auf das Verhindern einer Beschädigung der Membran durch eindringende Fremdkörper. Durch diese Ausgestaltung ist somit indirekt auch der Schutz des Druckausgleichselements vor äußeren Einflüssen erhöht.

Gleichzeitig können die Druckausgleichselemente serienmäßig in großer Stückzahl hergestellt werden, da der Innendurchmesser von Kabelverschraubungen normiert ist und lediglich die Kapsel des Druckausgleichselements hieran angepaßt werden muß. Die Gehäuse weisen zumeist eine oder mehrere Bohrungen auf, die für derartige Kabelverschraubungen normiert sind. Es ist daher nicht mehr erforderlich, für eine Vielzahl unterschiedlicher Bohrungen in der Wandung des Gehäuses jeweils individuell im Umfang angepaßte Druckausgleichselemente bereitzustellen. Die Herstellungskosten der Druckausgleichselemente lassen sich dadurch weiter reduzieren. Darüber hinaus können Gehäuse mit vorhandener Kabelverschraubung kostengünstig mit einem passenden Druckausgleichselement nachgerüstet werden.

Das Druckausgleichselement weist bevorzugt die äußere Form eines herkömmlichen Blindstopfens für die jeweilige Kabelverschraubung auf. Mit Vorteil wird das Druckausgleichselement mit Ausnahme des Deckels vollständig von der Kabelverschraubung aufgenommen, wobei der Deckel eine an die Hutmutter angepaßte äu-βere Form aufweist. Hierdurch wird die Angriffsfläche des Druckausgleichselements gegenüber mechanischen Einwirkungen von außerhalb des Gehäuses weiter reduziert.

Weitere Einzelheiten und Vorteile der Erfindung ergeben sich aus den Unteransprüchen und den in den Figuren schematisch dargestellten Ausführungsbeispielen, die im folgenden beschrieben werden; es zeigen:
- Fig. 1: eine erfindungsgemäße Anordnung in einer Schnittdarstellung, mit einem Druckausgleichselement, eingesetzt in eine Kabelverschraubung,
- Fig. 2: das Druckausgleichselement aus Fig. 1 in vergrößerter Darstellung,
- Fig. 3: das Druckausgleichselement aus Fig. 1 in einer die Einzelteile illustrierenden Darstellung,
- Fig. 4: ein erfindungsgemäßes Druckausgleichselement zum Einschrauben in geschnittener Darstellung,
- Fig. 5: ein weiteres erfindungsgemäßes Druckausgleichselement zum Einschrauben in einer Schnittdarstellung und
- Fig. 6: den Gegenstand aus Fig. 5 in der Draufsicht.

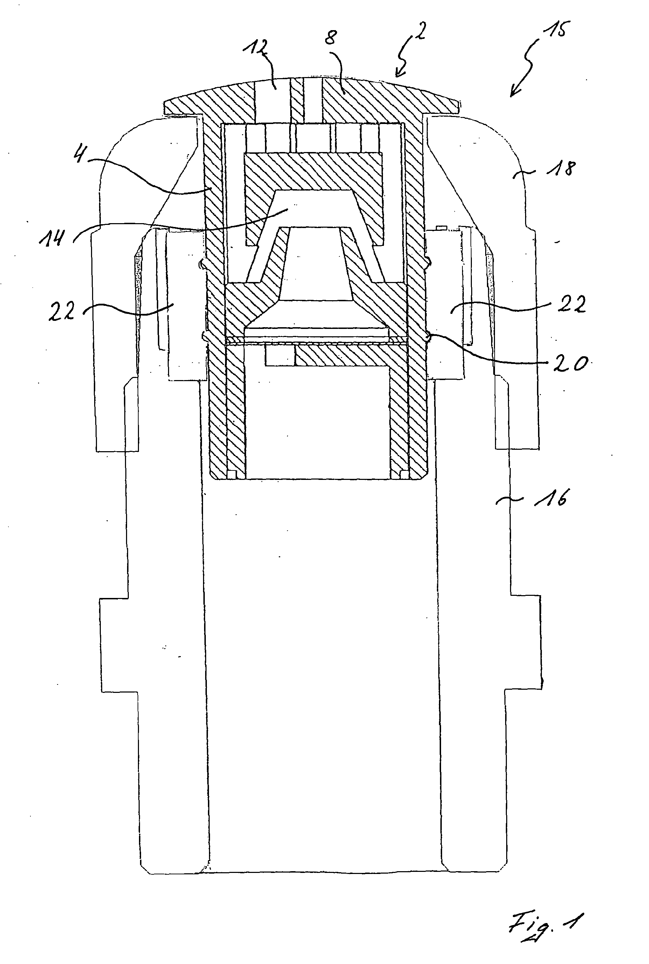

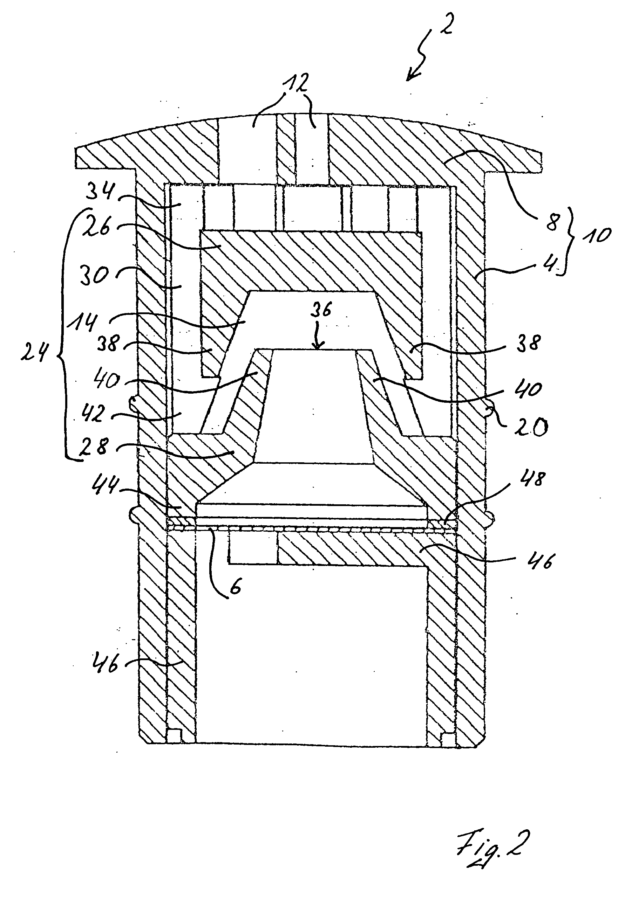

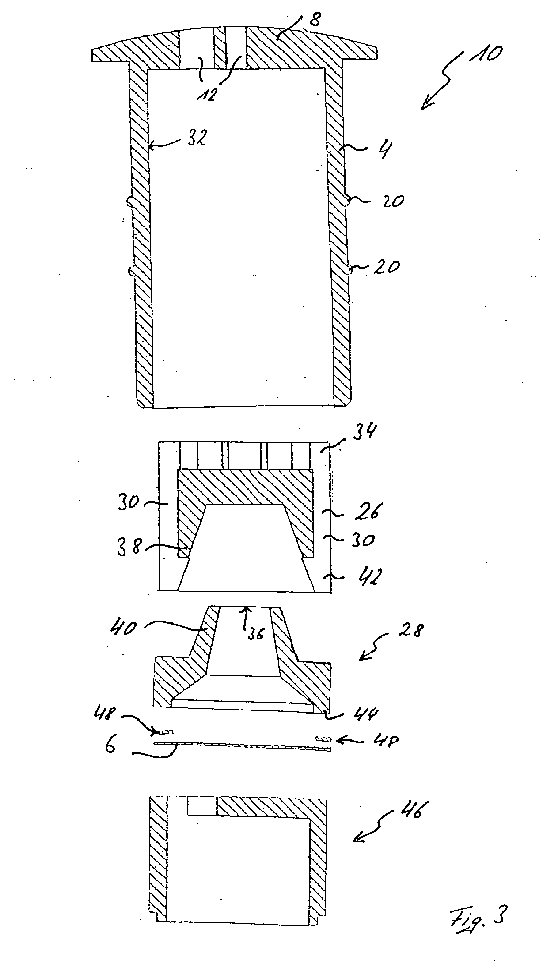

Nachfolgend werden gleiche oder gleichwirkende Elemente der Erfindung einheitlich mit einer Bezugsziffer versehen. Fig. 1 bis 3 zeigen insgesamt ein erfindungsgemäßes Druckausgleichselement 2 mit einem Aufnahmeteil 4, in dem eine semipermeable Membran 6 angeordnet ist. Das Druckausgleichselement 2 weist einen Deckel auf, der in den Figuren als Schlagschutzelement 8 ausgebildet ist und das Aufnahmeteil 4 und die Membran 6 vor mechanischen Einwirkungen von außerhalb des Druckausgleichselements 2 schützt. Dabei sind das Aufnahmeteil 4 und das Schlagschutzelement 8 als einteilige Kapsel 10 ausgebildet, die die Außenhülle des Druckausgleichselements 2 bildet. Die Kapsel 10 weist im Bereich des Schlagschutzelements 8 Durchbrüche 12 zur Be- und Entlüftung des Innenraums Aufnahmeteils 4 bzw. des Innenraums der Kapsel 10 auf. Nachfolgend wird der Innenraum des Aufnahmeteils 4 und der Innenraum der Kapsel 10 der einfachheithalber einheitlich als Kapselinneres 14 bezeichnet.

Fig. 1 zeigt eine erfindungsgemäße Anordnung 15 mit einem Druckausgleichselement 2, das in eine Kabelverschraubung 16 eingesetzt und mit einer Hutmutter 18 fixiert ist. Die äußere Form des Druckausgleichselements 2 ist komplementär zur inneren Form der Kabelverschraubung 16 ausgebildet. Das Schlagschutzelement 8 ist außenseitig, also auf der dem Kapselinneren abgewandten Seite, bereichsweise abgerundet. Die Abrundung ist dabei der Art nach einer Kugelkappe nachempfunden. Dabei wird das Druckausgleichselement 2 mit Ausnahme des Schlagschutzelements 8 vollständig von der Kabelverschraubung 16 aufgenommen und das Schlagschutzelement 8 hat eine an die Hutmutter 18 angepaßte äußere Form. Durch diese Ausgestaltung ist die Angriffsfläche des Druckausgleichselements 2 deutliche eingeschränkt.

Das Schlagschutzelement 8 kann dabei, wie dargestellt, auf der Hutmutter 18 aufliegen und dadurch ein Hineinrutschen des Druckausgleichselements 2 in die Kabelverschraubung 16 verhindern. In einer hier nicht dargestellten Ausführung kann das Schlagschutzelement 8 jedoch auch umfänglich vollständig in der Öffnung der Hutmutter 18 untergebracht sein. Hierdurch wird die Angriffsfläche des Druckausgleichselements 2 weiter reduziert.

Zur Anpassung des Druckausgleichselements 2 an die Kabelverschraubung 16 ist das Aufnahmeteil 4 rundzylindrisch ausgebildet und weist zudem eine an die jeweilige Kabelverschraubung 16 angepaßte Länge auf. Zur besseren Fixierung des Druckausgleichselements 2 in der Kabelverschraubung 16 weist das Aufnahmeteil 4 außenseitig umlaufende Vorsprünge 20 in der Höhe einer Dichtung 22 der Kabelverschraubung 16 auf.

Das Druckausgleichselement 2 weist ein Labyrinthsystem 24 auf, das die Membran 6 vor in das Aufnahmeteil 4 bzw. in das Kapselinnere 14 eindringende Fremdkörper schützt. Der Schutz bezieht sich dabei auf einen Schutz vor durch die Durchbrüche 12 ins Kapselinnere 14 gelangende Fremdkörper. Das Labyrinthsystem 24 weist eine erste Schikane 26 und eine weitere Schikane 28 auf. Die erste Schikane 26 ist zwischen dem Schlagschutzelement 8 und der Membran 6 angeordnet und schützt die Membran 6 vor einer direkten Einwirkung von ins Kapselinnere 14 gelangenden Fremdkörpern. Bereits durch die erste Schikane 26 kann also beispielsweise ein durch die Durchbrüche 12 ins Kapselinnere eindringender Fremdkörper nicht in gerader Flugbahn auf die Membran 6 treffen, sondern wird abgelenkt. Hierzu füllt die erste Schikane 25 den Querschnitt des Kapselinneren 14 unterhalb des Schlagschutzelements 8 vollflächig aus mit Ausnahme eines oder mehrerer Kanäle 30. Die Kanäle 30 sind dabei außerhalb gerader Strecken zwischen den Durchbrüchen 12 des Schlagschutzelements 8 und der Membran 6 angeordnet. Diese versetzte Anordnung zu den Durchbrüchen 8 bzw. der Membran 6 verhindert die zuvor beschriebene direkte Einwirkung von ins Kapselinnere 14 gelangenden Fremdkörpern auf die Membran 6.

Bevorzugt sind mehrere Kanäle 30 vorgesehen, die jeweils einerseits von der ersten Schikane 26 und andererseits von der Innenwandung 32 der Kapsel 10 begrenzt werden. Im Falle einer Kapsel 10, deren Aufnahmeteil 4 zylindrisch ausgebildet ist, hat die erste Schikane 26 einen ebenfalls runden Querschnitt gleichen Durchmessers wie das Aufnahmeteil 4 und weist außenseitig verteilte Ausnehmungen als Kanäle 30 auf. Durch diese Anordnung ist einerseits die Blockierfunktion der ersten Schikane 26 sichergestellt und andererseits kann genügend Luft die erste Schikane 26 passieren.

Zwischen der ersten Schikane 26 und dem Schlagschutzelement 8 ist wenigstens ein erster Abstandshalter 34 angeordnet. In der dargestellten, bevorzugten Ausgestaltung ist der Abstandshalter 34 einteilig mit der ersten Schikane 26 verbunden. Erster Abstandshalter 34 und erste Schikane 26 bilden eine einteilige Baugruppe. Die Baugruppe kann dadurch kostengünstig hergestellt und montiert werden.

Die weitere Schikane 28 ist derart ausgebildet, daß sie einen an der ersten Schikane 26 vorbeigelangten Fremdkörper wenigstens zeitweilig um zumindest 90 Grad, besser jedoch um 115 Grad und insbesondere um 130 Grad ablenkt. Dabei füllt die weitere Schikane den Querschnitt des Kapselinneren 14 unterhalb der ersten Schikane 26 vollflächig aus mit Ausnahme einer Öffnung 36, die außerhalb gerader Strecken zwischen dem Ausgang der Kanäle 30 und der Membran 6 angeordnet ist.

Die erste Schikane 26 weist auf der dem Schlagschutzelement 8 abgewandten Seite einen umlaufenden ersten Vorsprung 38 auf, wohingegen die weitere Schikane 28 auf der der ersten Schikane 26 zugewandten Seite einen weiteren Vorsprung 40 aufweist. Dabei ragt der erste Vorsprung 38 in Richtung zur Membran 6 hin über den weiteren Vorsprung 40 hinaus. Hierdurch muß ein in das Labyrinthsystem gelangender Fremdkörper, der am ersten Vorsprung 38 vorbeigelangt ist, seine Bewegungsrichtung deutlich ändern, um auch am weiteren Vorsprung 30 vorbei zu gelangen und auf die Membran 6 zu treffen. Zwischen erster Schikane 26 und weiterer Schikane 28 sind weitere Abstandshalter 42 angeordnet. In der dargestellten, bevorzugten Ausgestaltung sind die weiteren Abstandshalter 42 als rückwärtige Verlängerungen der ersten Abstandshalter 34 ausgebildet. Die erste Schikane 26 sowie die ersten Abstandshalter 34 und die weiteren Abstandshalter 42 bilden dabei eine einteilige Baugruppe mit den bereits zuvor genannten Vorteilen.

Die weitere Schikane 26 weist einen umlaufenden Niederhalter 44 auf. Die Membran 6 wird einerseits von dem Niederhalter 44 und andererseits von einem Membranträger 46 direkt oder indirekt fixiert. Hierdurch erfüllt die weitere Schikane 28 in einem Bauteil neben der Labyrinthfunktion auch noch die Funktion einer Halterung für die Membran 6.

Der erste Vorsprung 38 und der weitere Vorsprung 40 sind jeweils in dem einander zugewandten Bereich kegelstumpfförmig ausgebildet. Die Mantelflächen der Kegelstümpfe sind dabei parallel zueinander. Dadurch bedingt kann die weitere Schikane 28 in einfacher Weise so ausgebildet werden, daß sich die Öffnung 36 der weiteren Schikane 28 zum Niederhalter 44 hin trichterförmig erweitert. Durch diese trichterförmige Erweiterung wird eine freie Membranfläche gewährleistet, die in vorteilhafter Weise relativ zum zur Verfügung stehenden Querschnitt des Aufnahmeteils 4 groß ausgebildet ist. Trotz kleiner Bauweise des Druckausgleichselements 2 wird dadurch der notwendige Luftaustausch über die Membran 6 sichergestellt.

Zwischen dem Niederhalter 44 und der Membran 6 ist ein Dichtungsring 48 aus einem elastischen Material angeordnet. Dieser hat neben der Dichtungsfunktion gleichzeitig eine Federfunktion. Diese besteht darin, daß die Membran 6 zwischen dem Niederhalter 44 und dem Membranträger 46 einerseits fest genug eingeklemmt ist, um Verrutschungen der Membran 6 zu verhindern, andererseits jedoch nicht durch die im Verhältnis zur Membran 6 härteren Materialien des Niederhalters 44 oder der des Membranträgers 46 beschädigt wird. Darüber hinaus besteht die Federfunktion darin, sämtliche lose Teile im Kapselinneren 14 an einem Wackeln und damit einem unerwünschten Gegeneinanderschlagen zu hindern. Ein geräuschvolles Klappern des Druckausgleichselements 2 wird dadurch wünschenswerter Weise vermieden.

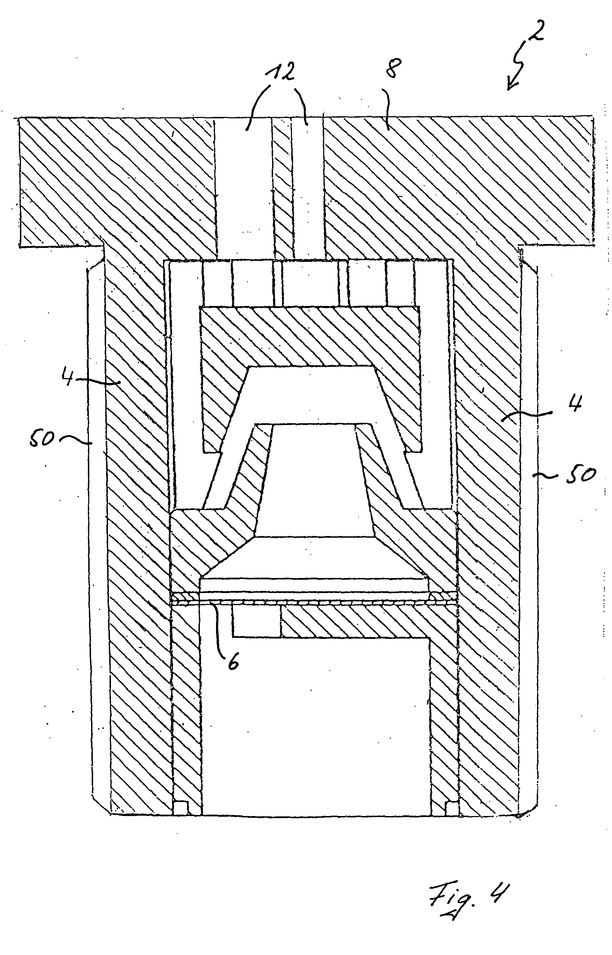

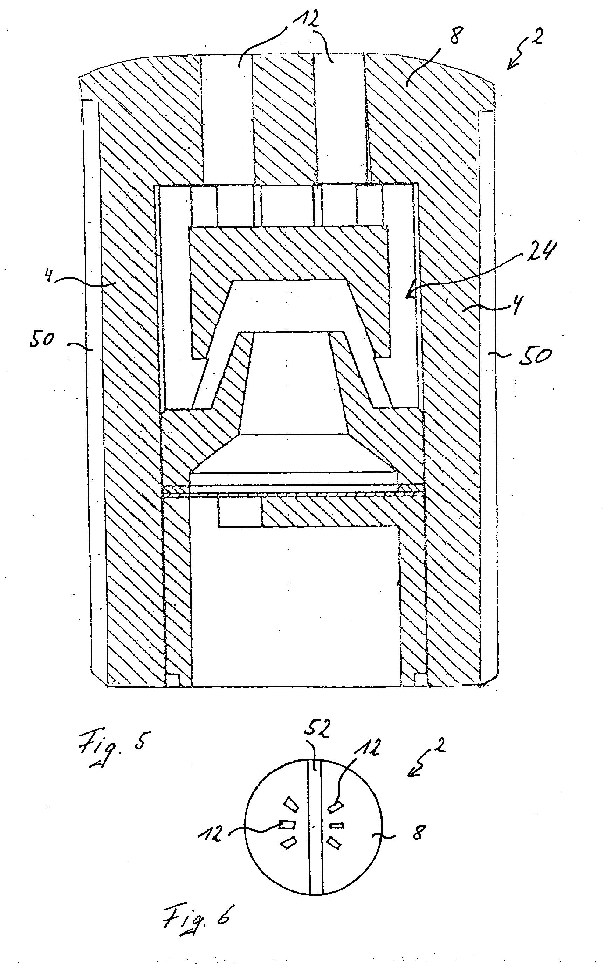

Fig. 4 und 5 zeigen jeweils weitere Ausgestaltungen eines erfindungsgemäßen Druckausgleichselements 2. Im Gegensatz zum in den Fig. 1 bis 3 gezeigten Ausführungsbeispiel weisen die Druckausgleichselemente 2 in den Fig. 4 und 5 ein Aussengewinde 50 am Aufnahmeteil 4 auf. Mit Hilfe des Außengewindes 50 können diese Druckausgleichselemente 2 in Bohrungen eines Gehäuses eingeschraubt werden. Die Fixierung und Abdichtung des Druckausgleichselements 2 erfolgt dabei in herkömmlicher Weise, zum Beispiel durch in den Figuren nicht dargestellte Gegenmuttern und einem Dichtungsring.

Das Schlagschutzelement 8 weist im Querschnitt die Form eines regelmäßigen Sechsecks auf und ist in der Dimensionierung an herkömmliche Sechskantschlüssel angepaßt. Das Druckausgleichselement 2 wird dabei mit Hilfe eines am Schlagschutzelement 8 angreifenden Sechskantschlüssels in das Gehäuse eingeschraubt.

In Fig. 5 und 6 ist eine weitere Ausführungsform des Druckausgleichselements 2 dargestellt. Wie aus Fig. 6 ersichtlich weist dieses eine nicht bis zum Kapselinneren 14 durchgehende Einkerbung 52 auf. Das Druckausgleichselement 2 wird mit einem Werkzeug in die Öffnung eines Gehäuses eingedreht. Das Werkzeug greift dabei in die vorgenannte Einkerbung 52 des Schlagschutzelements 8 ein. Fig. 6 zeigt zudem die Anordnung der Durchbrüche 12 des Schlagschutzelements 8. Diese Anordnung ist im wesentlichen auch bei den bisher beschriebenen Ausführungsbeispielen beibehalten.

Wie aus Fig. 1 bis 5 ersichtlich, weist die Kapsel 10 an der dem Schlagschutzelement 8 gegenüberliegenden Seite eine Kapselöffnung 54 auf, durch die das Kapselinnere 14 mit dem Labyrinthsystem 24, dem Dichtungsring 48, der Membran 6 und dem Membranträger 46 befüllbar ist. Diese im Kapselinneren 14 untergebrachten, losen Teile (24, 48, 6, 46) werden einenends von dem Schlagschutzelement 8 an einem Herausfallen aus der Kapsel 10 gehindert. Der Membranträger 46 weist zudem eine Nut 56 auf, die zur Kapselinnenseite 32 und zur Kapselöffnung 54 hin offen ist. Die Nut 56 kann umlaufend oder auch nur bereichsweise eingebracht am Membranträger 46 vorgesehen sein. Nach dem Befüllen des Kapselinneren 14 mit den zuvor genannten losen Teilen (24, 48, 6, 46) wird ein Teil der Kapsel 10 im Bereich der Kapselöffnung 54 durch thermische Verformung in die Nut 56 gedrückt und mit dem Membranträger 46 verschmolzen. Die Nut 56 kann dabei auch Teil eines separaten, in den Figuren nicht dargestellten Verschlußelements sein, das am Membranträger 46 abgestützt ist. Die Fixierung des Membranträgers 46 an der Kapsel 10 kann aber auch durch Verkleben, Verklemmen, Verkeilen oder einen Schnappverschluß oder dergleichen erfolgen.

In den Figuren ist die Nut 56 lediglich im noch nicht mit der Kapsel 10 verschweißten Zustand dargestellt. Mit Hilfe der Schweißnaht in der Nut 56 werden die im Kapselinneren 14 untergebrachten losen Teile (24, 48, 6, 46) auf einfache und kostengünstige Weise wirksam an einem Herausfallen aus der Kapselöffnung 54 gehindert. Zudem wird beim Verschweißen der Kapsel 10 in der Nut 56 auf die losen Teile im Kapselinneren 14 ein leichter Druck in Richtung Schlagschutzelement 8 aufgebracht. Hierdurch wird der Dichtungsring 48 geringfügig zusammengedrückt und in diesem Zustand beim Erkalten der Schweißwulst fixiert. Im verschweißten Zustand des Druckausgleichselements 2 werden dadurch die losen Teile (24, 48, 6, 46) im Kapselinneren 14 an einem unerwünschten Wackeln gehindert, wie zuvor bereits beschrieben.

## Patentansprüche

1. Druckausgleichselement (2) zum Verschließen eines Zugangs zu einem Gehäuse, mit einem Aufnahmeteil (4), in dem eine semipermeable Membran (6) angeordnet ist, und einem das Aufnahmeteil (4) zumindest bereichsweise verschließenden Deckel (8), **dadurch gekennzeichnet, daß** das Druckausgleichselement (2) zwischen dem Deckel (8) und der Membran (6) ein Labyrinthsystem (24) aufweist, das die Membran (6) vor an dem Deckel (8) vorbei in das Aufnahmeteil (4) eindringenden Fremdkörpern schützt.

2. Druckausgleichselement (2) nach Anspruch 1, **dadurch gekennzeichnet, daß** das Labyrinthsystem (24) in das Aufnahmeteil (4) eindringende Fremdkörper wenigstens zeitweilig um mindestens 90 Grad, insbesondere um mindestens 180 Grad, ablenkt.

3. Druckausgleichselement (2) nach Anspruch 1 oder 2, **dadurch gekennzeichnet, daß** das Labyrinthsystem (24) zumindest eine Schikane (26) aufweist.

4. Druckausgleichselement (2) nach Anspruch 3, **dadurch gekennzeichnet, daß** der Deckel zumindest einen Durchbruch (12) und die Schikane (26) zwischen dem Deckel (8) und der Membran (6) angeordnet ist und die Membran (6) vor einer direkten Einwirkung von durch den oder die Durchbrüche (12) ins Aufnahmeteil (4) gelangenden Fremdkörpern schützt.

5. Druckausgleichselement (2) nach Anspruch 3 oder 4, **dadurch gekennzeichnet, daß** die Schikane (26) den Querschnitt des Aufnahmeteils (4) unterhalb des Deckels (8) vollflächig ausfüllt mit Ausnahme wenigstens eines Kanals (30), der außerhalb gerader Strecken zwischen den Durchbrüchen (12) des Deckels (8) und der.Membran (6) angeordnet ist.

6. Druckausgleichselement (2) nach einem der Ansprüche 3 bis 5, **dadurch gekennzeichnet, daß** zwischen der Schikane (26) und dem Deckel (8) wenigstens ein Abstandshalter (34) angeordnet ist, der einteilig mit der Schikane (26) verbunden ist.

7. Druckausgleichselement (2) nach einem der Ansprüche 3 bis 6, **gekennzeichnet durch** wenigstens eine weitere Schikane (28).

8. Druckausgleichselement (2) nach Anspruch 7, **dadurch gekennzeichnet, daß** die weitere Schikane (28) derart ausgebildet ist, daß sie einen an der ersten Schikane (26) vorbei gelangten Fremdkörper wenigstens zeitweilig um zumindest 90 Grad, insbesondere um zumindest 130 Grad, ablenkt.

9. Druckausgleichselement (2) nach einem der Ansprüche 7 oder 8, **dadurch gekennzeichnet, daß** die weitere Schikane (28) den Querschnitt des Aufnahmeteils (4) unterhalb der ersten Schikane (26) vollflächig ausfüllt mit Ausnahme wenigstens einer Öffnung (36), die außerhalb gerader Strecken zwischen dem Kanal (30) und der Membran (6) angeordnet ist.

10. Druckausgleichselement (2) nach einem der Ansprüche 7 bis 9, **dadurch gekennzeichnet, daß** die erste Schikane (26) auf der dem Deckel (8) abgewandten Seite einen umlaufenden ersten Vorsprung (38) und die weitere Schikane (28) auf der der ersten Schikane (26) zugewandten Seite einen weiteren Vorsprung (40) aufweist, wobei der erste Vorsprung (38) in Richtung zur Membran (6) hin über den weiteren Vorsprung (40) hinausragt und zwischen erstem und weiterem Vorsprung (40) ein Abstand verbleibt.

11. Druckausgleichselement (2) nach einem der Ansprüche 7 bis 10, **dadurch gekennzeichnet, daß** zwischen erster Schikane (26) und weiterer Schikane (28) wenigstens ein weiterer Abstandshalter (42) angeordnet ist, der als rückwärtige Verlängerung des ersten Abstandshalters (34) ausgebildet ist.

12. Druckausgleichselement (2) nach einem der Ansprüche 7 bis 11, **dadurch gekennzeichnet, daß** die weitere Schikane (28) einen umlaufenden Niederhalter (44) aufweist und die Membran (6) einerseits von dem Niederhalter (44) und andererseits von einem Membranträger (46) direkt oder indirekt fixiert wird.

13. Druckausgleichselement (2) nach einem der Ansprüche 7 bis 12, **dadurch gekennzeichnet, daß** sich die Öffnung (36) der weiteren Schikane (28) zum Niederhalter (44) hin trichterförmig erweitert.

14. Druckausgleichselement (2) nach einem der Ansprüche 7 bis 13, **dadurch gekennzeichnet, daß** zwischen dem Niederhalter (44) und der Membran (6) ein Dichtungsring (48) aus einem elastischen Material angeordnet ist.

15. Druckausgleichselement (2) nach einem der vorhergehenden Ansprüche, **dadurch gekennzeichnet, daß** der Deckel (8) als das Aufnahmeteil (4) und die Membran (6) vor mechanischen Einwirkungen von außerhalb schützendes Schlagschutzelement (8) ausgebildet ist und das Aufnahmeteil (4) und das Schlagschutzelement (8) als einteilige Kapsel (10) ausgebildet sind.

16. Druckausgleichselement (2) nach Anspruch 15, **dadurch gekennzeichnet, daß** die Kapsel (10) die Außenhülle des Druckausgleichselements (2) bildet.

17. Druckausgleichselement (2) nach einem der vorhergehenden Ansprüche, **dadurch gekennzeichnet, daß** das Schlagschutzelement (8) außenseitig zumindest teilweise abgerundet ist.

18. Anordnung (15) zur flüssigkeitsdichten Be- und Entlüftung eines Gehäuses mit einer Kabelverschraubung, **gekennzeichnet durch** ein Druckausgleichselement (2) nach einem der Ansprüche 1 bis 17, wobei die äußere Form des Druckausgleichselements (2) komplementär zur inneren Form der Kabelverschraubung (16) ausgebildet ist.

19. Anordnung (15) nach Anspruch 18, **dadurch gekennzeichnet, daß** das Druckausgleichselement (2) mittels Hutmutter (18) in der Kabelverschraubung (16) fixierbar ist.

20. Anordnung (15) nach Anspruch 18 oder 19, **dadurch gekennzeichnet, daß** das Druckausgleichselement (2) die äußere Form eines Blindstopfens der Kabelverschraubung (16) aufweist.

21. Anordnung (15) nach Anspruch 19 oder 20, **dadurch gekennzeichnet, daß** das Druckausgleichselement (2) mit Ausnahme des Deckels (8) vollständig von der Kabelverschraubung (16) aufgenommen wird und der Deckel (8) eine an die Hutmutter (18) angepaßte äußere Form aufweist.

22. Anordnung (15) nach einem der Ansprüche 18 bis 21, **dadurch gekennzeichnet, daß** das Aufnahmeteil (4) außenseitig wenigstens einen Vorsprung (20) zur besseren Fixierung des Druckausgleichselements (2) in der Kabelverschraubung (16) aufweist.
